# EUROPÄISCHE PATENTSCHRIFT

(11) **EP 1 097 387 B1**
(45) Veröffentlichungstag und Bekanntmachung des Hinweises auf die Patenterteilung: **05.02.2003**
(21) Anmeldenummer: 99960693.2
(22) Anmeldetag: 11.07.1999
(51) Int. Cl.: G01R 31/01

(54) **RÜSTSATZFREIE VORRICHTUNG ZUM ZIELGERICHTETEN BEWEGEN VON ELEKTRONISCHEN BAUTEILEN**
DEVICE WITHOUT SET-UP KIT FOR THE TARGETED MOVING OF ELECTRONIC COMPONENTS
DISPOSITIF SANS ENSEMBLE D'ADAPTATION POUR DEPLACER DE MANIERE CIBLEE DES COMPOSANTS ELECTRONIQUES

(30) Priorität: 11.07.1998 DE 29812292 U
(43) Veröffentlichungstag der Anmeldung: 09.05.2001
(73) Patentinhaber: Sysko Gesellschaft für elektronische Serienfertigung, serielle Lohnbestückung und Kabelkonfektionierung mbH, 83278 Traunstein (DE)
(72) Erfinder: MEISSNER, Hans-Georg, D-83233 Bernau (DE); HEINZ, Jürgen, F-57600 Oeting (FR)
(86) Internationale Anmeldenummer: DE9902119
(87) Internationale Veröffentlichungsnummer: WO00003255

(56) Entgegenhaltungen:
- GB-A- 2 291 737
- US-A- 5 436 569
- US-A- 5 451 884
- US-A- 5 690 467

## Beschreibung

Die vorliegende Erfindung betrifft eine rüstsatzfreie Vorrichtung zum zielgerichteten Bewegen von elektronischen Bauteilen mit den im Oberbegriff des Patentanspruchs 1 angegebenen Merkmalen.

Vorrichtungen zum zielgerichteten Bewegen von elektronischen Bauteilen sind insbesondere beim Testen und Sortieren nach Güteklassen von elektronischen Bauteilen erforderlich. Während des eigentlichen Testvorganges wird das zu prüfende elektronische Bauteil zunächst in leitenden Kontakt mit einer elektrischen Kontakteinrichtung (zum Beispiel mit einem Prüfsockel) gebracht. In Abhängigkeit von dem Prüfergebnis erfolgt anschließend eine Sortierung oder Markierung nach Güteklassen.

Aus dem Stand der Technik ist eine Vorrichtung zum Handhaben von elektronischen Bauteilen bekannt, bei welcher die zu testenden elektronischen Bauteile auf trägerartigen Rüstsätzen in Platten- oder Streifenform angeliefert und innerhalb der Handhabungsvorrichtung positioniert auf diesen Rüstsätzen bewegt werden.

So wird in der US-A-5436569 ein Hot-Zone-Tester zur gleichzeitigen künstlichen Alterung von zahlreichen elektronischen Bauelementen beschrieben, bei welchem eine Vielzahl von mit elektronischen Komponenten bestückten Platten dicht nebeneinander stehend in einen Träger eingesteckt werden. Mehrere der mit vielen Platten beladenen Träger werden dann an einem Transportband angebracht, welches L-förmig in einer Ofenkammer endlos umläuft. Während ihres Weges durch die Ofenkammer werden die Träger über parallel zum Transportband verlaufende Stromleitungen zu Testzwecken abschnittsweise unterschiedlichen Spannungen ausgesetzt.
Außerhalb der Temperaturkammer ist eine Handhabungsvorrichtung zum Beladen des Förderbandes vorgesehen.

Derartige Handhabungsvorrichtungen mit platten- oder streifenförmigen Rüstsätzen weisen zahlreiche Nachteile auf:

Einerseits ist die Verbindung zwischen dem platten- oder streifenförmigen Rüstsatz und dem Prüfsockel der elektrischen Prüfvorrichtung stets toleranzbehaftet. Andererseits besteht ein Spiel zwischen der Einbettung des elektronischen Bauteils in dem platten- oder streifenförmigen Rüstsatz und dem elektronischen Bauteil.
Schließlich ist diese bekannte Vorrichtung nur mit erheblichem Aufwand für das Testen von unterschiedlichen Arten elektronischer Bauteile umrüstbar.

Ferner unterliegen die platten- oder streifenförmigen Rüstsätze einem erheblichen Verschleiß während des Transportes innerhalb und/oder außerhalb der Handhabungsvorrichtung sowie beim Beschicken mit elektronischen Bauteilen. Dieser Verschleiß drückt sich in einer Zunahme von Toleranzen und damit in einer Verkürzung der Standzeit aus.

Die Anschaffung der platten- oder streifenförmigen Rüstsätze ist darüberhinaus mit erheblichen Kosten und Wartezeiten verbunden. Denn für jede Variante eines elektronischen Bauteils ist ein separater, aufwendig herzustellender Rüstsatz in Form eines platten- oder streifenförmigen Träger-Sets erforderlich.
Die Kosten eines Rüstsatzes belaufen sich in der Regel auf einen Betrag von mindestens US$ 20.000,00. Die Lieferzeit für einen Rüstsatz beträgt aufgrund des erheblichen konstruktiven und fertigungstechnischen Aufwandes mindestens 60 bis 90 Tage.

Nachteilig ist ferner daß bei dem Übergang von einer Art elektronischer Bauteile zu einer anderen Art elektronischer Bauteile, der platten- oder streifenförmige Rüstsatz sowie die hierzu paßgenau ausgebildete Vorrichtung zur Bewegung der elektronischen Bauteile gewechselt werden muß.

Dieser Rüstsatz-Wechsel und der Austausch der Bewegungsvorrichtung gehen mit erheblichen zeitlichen Verzögerungen (ca. 4 Stunden) einher, innerhalb derer die Prüfvorrichtung nicht zum Testen von elektronischen Bauteilen verwendet werden kann.

Außerdem ist die dortige Handhabungsvorrichtung nach der Einführung eines neuen platten- oder streifenförmigen Rüstsatzes und einer neuen Vorrichtung zur Bewegung elektronischer Bauteile nicht sofort wieder betriebsbereit.

Vielmehr muß die Paßgenauigkeit und Funktionsfähigkeit des neuen Rüstsatzes und der hierzu paßgenau ausgebildeten Bewegungsvorrichtung in langwierigen Testreihen und unter Einsatz einer großen Anzahl von gegebenenfalls sehr teuren elektronischen Original-Bauteilen zunächst ausgetestet werden.

Darüberhinaus erfordert die Aufbewahrung von nicht in Gebrauch befindlichen Rüstsätzen spezielle kostenintensive Aufbewahrungbehältnisse sowie ein gut organisiertes und aufwendiges Lagersystem.

Aus dem Stand der Technik ist ferner eine Vorrichtung zur Handhabung elektronischer Bauteile bekannt, bei welcher die elektronischen Bauteile nicht auf einem platten- oder streifenförmigen Rüstsatz, sondern einzeln und stückweise einem Prüfsockel zugeführt und im Anschluß an die Prüfung sortiert werden.
Von Nachteil ist bei dieser Handhabungsvorrichtung insbesondere, daß es unter Erzeugung einer erheblichen Ausschußquote häufig zu Beschädigungen der fußförmigen oder kugelförmigen Kontakte der elektronischen Bauteile kommt.

Aufgabe der vorliegenden Erfindung ist daher die Bereitstellung einer Vorrichtung zum zielgerichteten Bewegen von elektronischen Bauteilen, welche insbesondere beim Einbringen von elektronischen Bauteilen in die Prüf-und Kontakteinrichtung - selbst bei sehr langer Nutzungsdauer - im wesentlichen nicht toleranzbehaftet ist und im wesentlichen spielfrei arbeitet, deren Verschleiß ausgesprochen gering ist und eine besonders lange Nutzungsdauer und Standzeit sicherstellt, welche für die Bewegung von elektronischen Bauteilen unterschiedlichster Gehäuseabmessungen, Kontaktarten und Kontaktabstände geeignet und hierbei nicht auf eigens an die jeweiligen elektronischen Bauteile angepaßte Rüstsätze und dazu paßgenau ausgestaltete Bewegungseinrichtungen für elektronische Bauteile angewiesen ist, deren Umstellung von einer Art elektronischer Bauteile auf eine andere Art elektronischer Bauteile nicht mit einem Rüstsatzwechsel und einem Wechsel der Bewegungseinrichtung und damit nicht mit erheblichen Kosten oder langen Stillstandzeiten der Handhabungsvorrichtung verbunden ist und welche im Falle einer Änderung der Art elektronischer Bauteile keinen aufwendigen und teuren Test der Funktionsfähigkeit und Paßgenauigkeit eines Rüstsatzes und des Zusammenspiels zwischen Rüstsatz und Bewegungseinrichtung erfordert und welche keines separaten Aufbewahrungsbehälters zur Aufbewahrung von nicht in Gebrauch befindlichen Rüstsätzen oder eines gut organisierten und aufwendigen Lagersystems hierfür bedarf.

Erfindungsgemäß wird diese Aufgabe bei einer gattungsgemäßen Vorrichtung durch die im Patentanspruch 1 angegebenen Merkmale gelöst. Besonders bevorzugte Ausführungsformen sind Gegenstand der Unteransprüche.

Ausführungsbeispiele der Erfindung werden anhand der Zeichnungen näher beschrieben. Es zeigen:

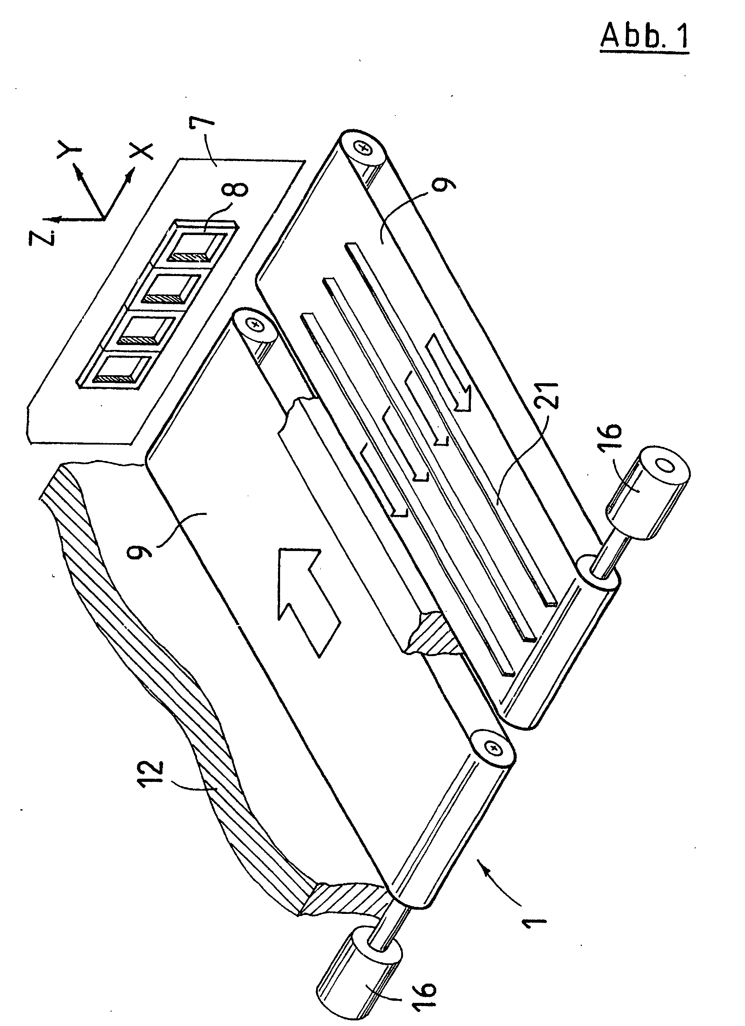

Abbildung 1 eine schematische, perspektivische Ansicht einer erfindungsgemäßen Vorrichtung zum zielgerichteten Bewegen von elektronischen Bauteilen mit zwei gegenläufigen Förderbändern und einer stirnseitigen elektrischen Kontakteinrichtung;

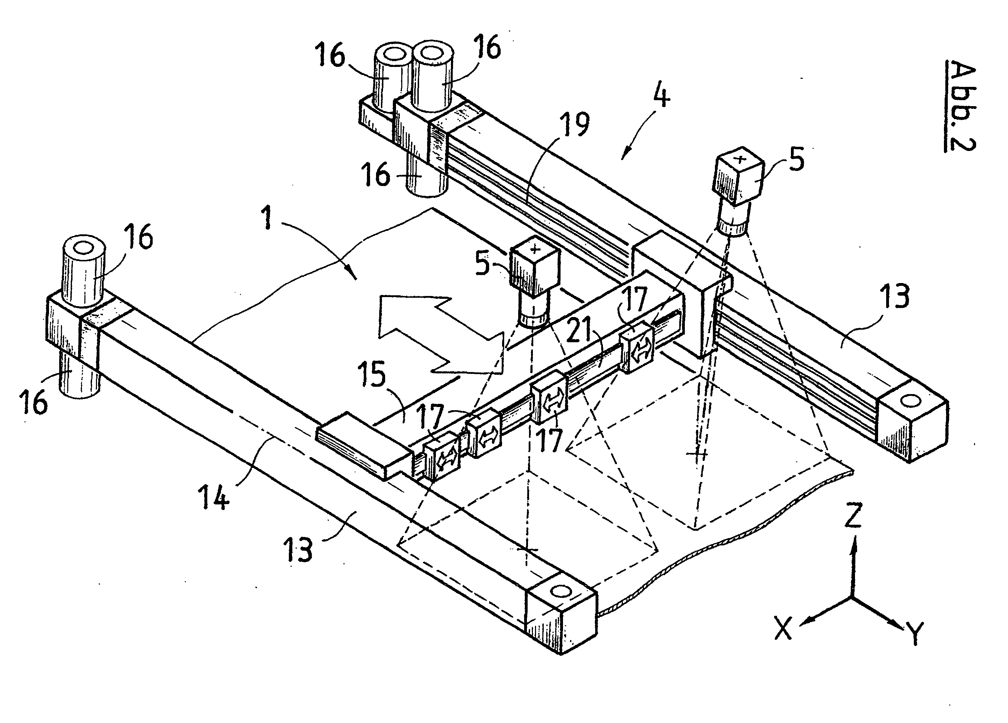

Abbildung 2 eine schematische, perspektivische Ansicht von schräg oben einer erfindungsgemäßen Verstelleinrichtung mit vier seitlich verschiebbaren, nur schematisch dargestellten Handhabungseinrichtungen auf einem entlang der parallelen Längsträger verschiebbaren Querträger;

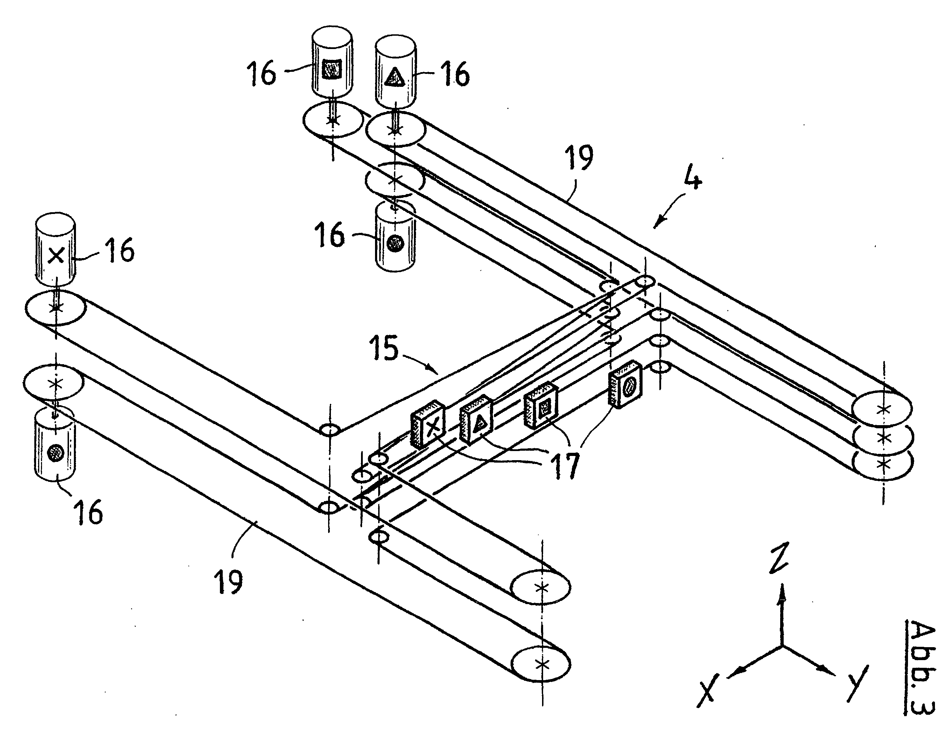

Abbildung 3 eine schematische Ansicht der beispielsweise in Abbildung 2 eingesetzten Seilzugmechanismen zur Verstellung des Querträgers der H-förmigen Verstelleinrichtung sowie von vier stirnseitig auf dem Querträger verschiebbar angebrachten und zeichnerisch nur angedeuteten vier Handhabungseinrichtungen;

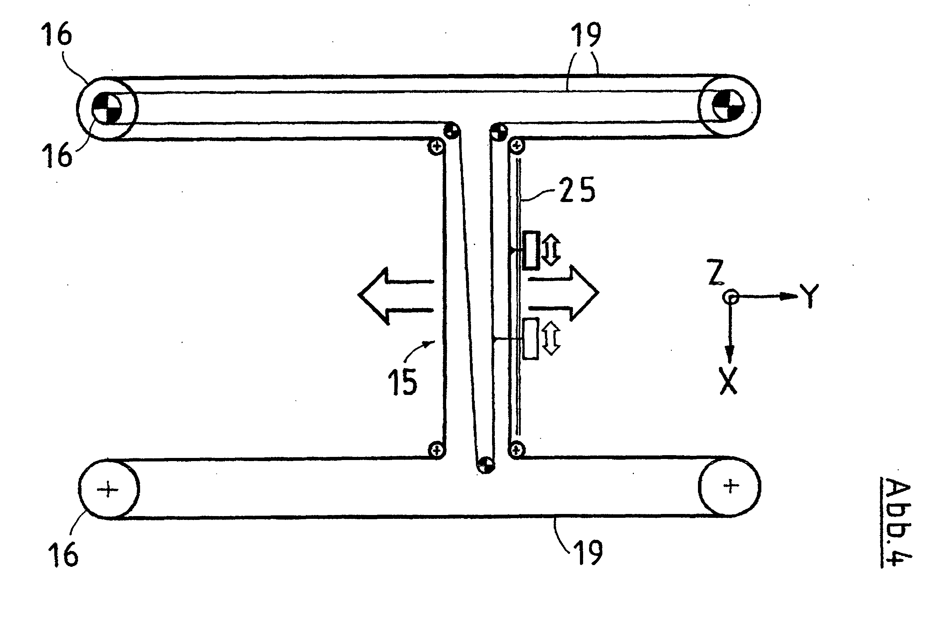

Abbildung 4 eine vereinfachte schematische Draufsicht auf einen Seilzugmechanismus gemäß Abbildung 3 mit zwei stirnseitig auf dem Querträger verschiebbar angebrachten Handhabungseinrichtungen, wobei der Seilzugmechanismus zum Antrieb des Querträgers in Form eines endlos umlaufenden Bandes ausgebildet ist und zugleich eine Handhabungseinrichtung in x-Richtung verschiebt;

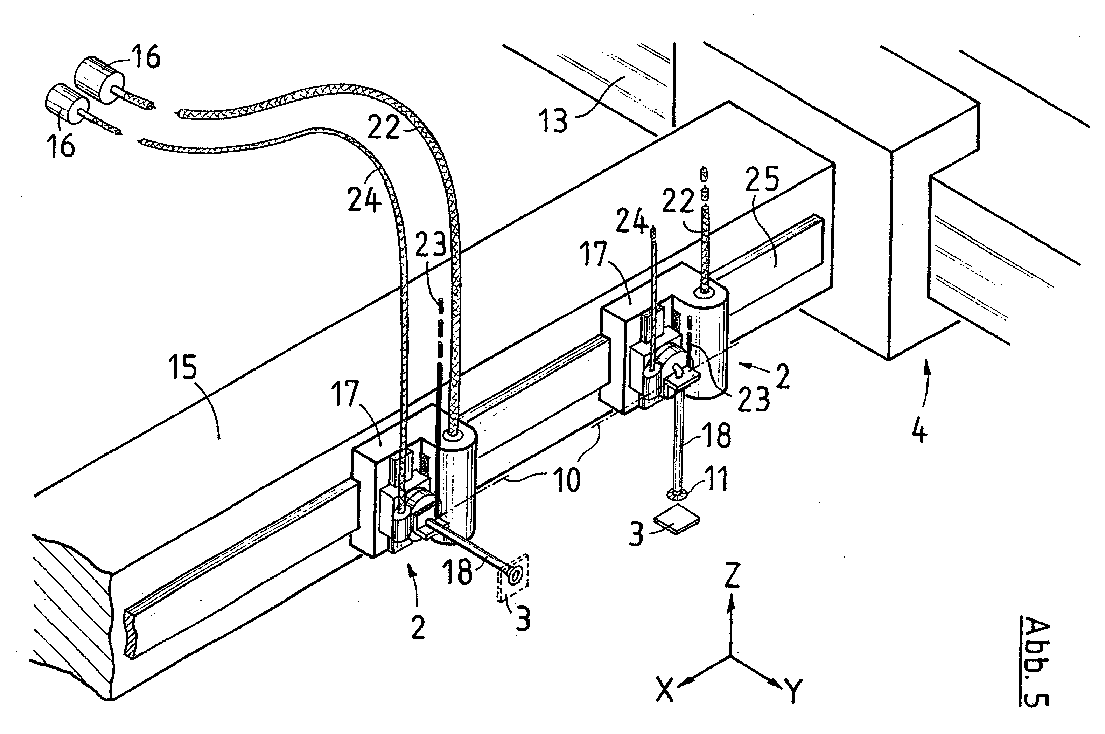

Abbildung 5 eine schematische Ansicht eines Querbalkens einer erfindungsgemäßen Verstelleinrichtung mit zwei etwas detaillierter dargestellten Handhabungseinrichtungen, wobei der Bauteilhalter der hinteren Handhabungseinrichtung zur Aufnahme eines elektronischen Bauteils senkrecht nach unten weist, während der Bauteilhalter der vorderen Handhabungseinrichtung in Kontaktierstellung horizontal ausgerichtet ist;

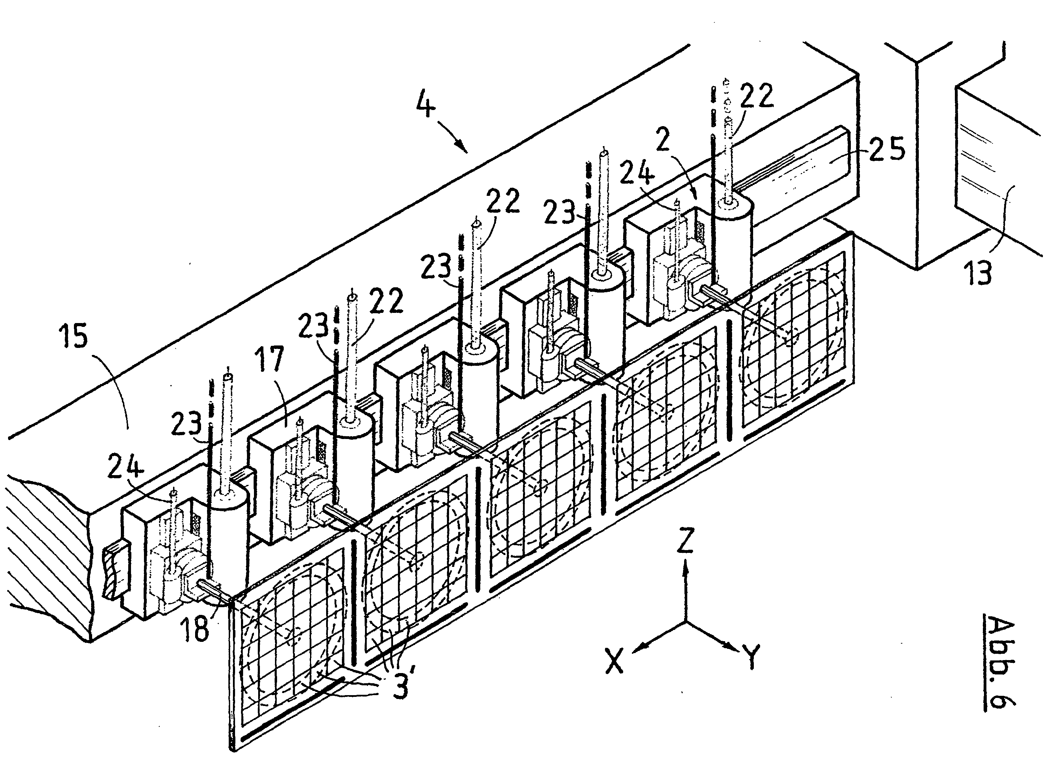

Abbildung 6 einen Querbalken einer erfindungsgemäßen H-förmigen Verstelleinrichtung mit fünf verschiebbaren Handhabungseinrichtungen auf der Stirnseite des Querbalkens der Verstelleinrichtung, wobei die fünf Bauteilhalter dieser Handhabungseinrichtungen mit verbreiterten Aufnahmeflächen jeweils an einer streifenförmigen Zusammenstellung von mehreren elektronischen Bauelementen in horizontaler Kontaktierstellung angreifen;

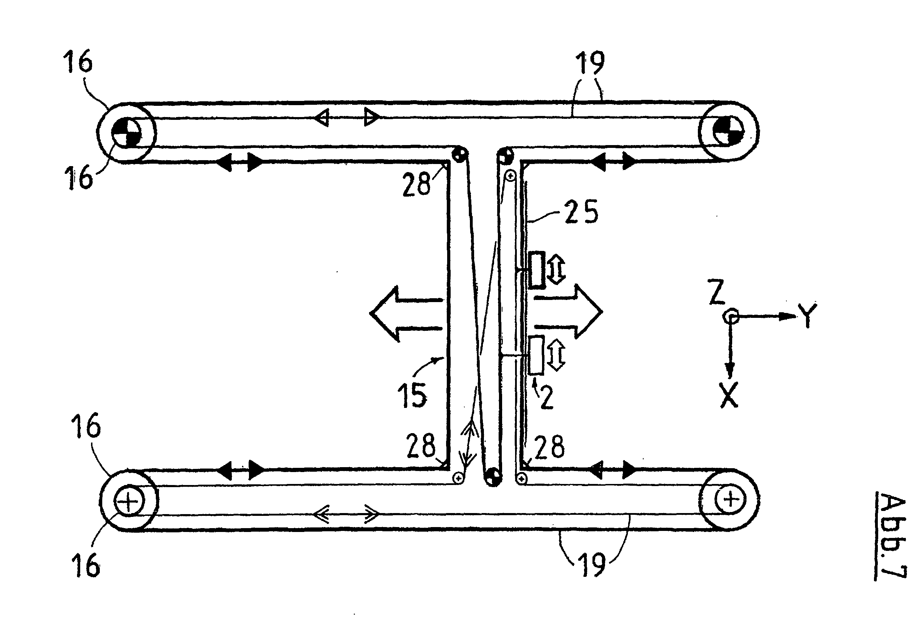

Abbildung 7 eine vereinfachte schematische Draufsicht auf einen Querträger-Bandantrieb und zwei Handhabungseinrichtung-Seilzugmechanismen zum Antrieb von zwei stirnseitig auf dem Querträger verschiebbar angebrachten Handhabungseinrichtungen, wobei die Enden des Querträger-Bandantriebes am Querträger selbst angebracht sind und jede Handhabungseinrichtung durch einen separaten Seilzugmechanismus in x-Richtung entlang des Querträgers verschiebbar ist;

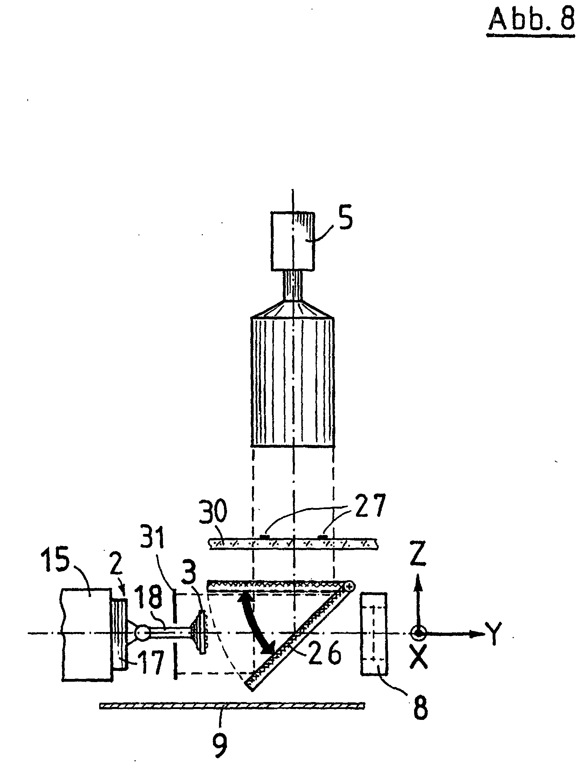

Abbildung 8 eine schematische, teilweise geschnittene Seitenansicht des Bereichs zwischen der Handhabungseinrichtung und der elektrischen Kontakteinrichtung, wobei in diesen Bereich ein- und ausschwenkbar eine Vorrichtung zur Umlenkung elektromagnetischer Strahlung vorgesehen ist, welche die Betrachtung der Unterseite eines elektronischen Bauteils durch eine Meßeinrichtung erlaubt.

Die erfindungsgemäße Vorrichtung zum zielgerichteten Bewegen von elektronischen Bauteilen umfaßt im wesentlichen mindestens ein Fördermittel (1) zur Anlieferung elektronischer Bauteile (3) in eine Temperaturkammer (12), wobei zumindest ein Abschnitt des Fördermittels (1) innerhalb der Temperaturkammer (12) vorgesehen ist.

Sie umfaßt ferner mindestens eine innerhalb der Temperaturkammer (12) vorgesehene Handhabungseinrichtung (2) zur Aufnahme eines oder mehrerer elektronischer Bauteile (3) von dem Fördermittel (1) und zum Bewegen eines oder mehrerer aufgenommener elektronischer Bauteile (3) in Richtung einer elektrischen Kontakteinrichtung (8) sowie zum Ablegen von einem oder mehreren elektronischen Bauteilen (3), wobei die Handhabungseinrichtung (2) neben der Aufnahme und dem Ablegen eines oder mehrerer elektronischer Bauteile (3) ein Schwenken und/oder Verschieben und/oder Drehen mindestens eines elektronischen Bauteils (3) um und/oder entlang der x- und/oder y- und/oder z-Achse erlaubt,

Die erfindungsgemäße Vorrichtung umfaßt weiterhin mindestens eine Verstelleinrichtung (4) zur Verstellung der Handhabungseinrichtung (2) um und/oder entlang der x-und/oder y- und/oder z-Achse sowie mindestens eine Meßvorrichtung (5) zur Bestimmung der Lage und der Ausrichtung der elektronischen Bauteile (3).

Als wesentliches Merkmal umfaßt die erfindungsgemäße Vorrichtung außerdem mindestens eine von der Handhabungseinrichtung (2) erreichbare, innerhalb der Temperaturkammer (12) vorgesehene elektrische Kontakteinrichtung (8) zur Herstellung mindestens einer elektrisch leitenden Verbindung zwischen mindestens einem elektronischen Bauteil (3) und mindestens einer der elektrischen Kontakteinrichtung (8) nachgeschalteten elektronischen Prüfeinrichtung.

Als wesentlichen Bestandteil umfaßt die erfindungsgemäße Vorrichtung ferner mindestens eine zentrale Datenverarbeitungseinrichtung, welche zumindest mit mindestens einer Meßvorrichtung (5) sowie mit mindestens einer der elektrischen Kontakteinrichtung (8) nachgeschalteten Prüfeinrichtung einerseits und den Antriebselementen (16) zum Antrieb der mindestens einen Handhabungseinrichtung (2) und/oder der mindestens einen Verstelleinrichtung (4) und/oder des mindestens einen Fördermittels (1,9) andererseits, in Verbindung steht.

Ein besonderes Merkmal der erfindungsgemäßen Vorrichtung ist darin zu sehen, daß sie eine Temperaturkammer (12) umfaßt, außerhalb welcher zumindest die Antriebsmittel (16) zur Bewegung des mindestens einen Fördermittels (1) und/oder der mindestens einen Handhabungseinrichtung (2) und/oder der mindestens einen Verstelleinrichtung (4) vorgesehen sind.
Durch diese Maßnahme erhöht sich die Lebensdauer der Antriebsmittel (16) beträchtlich.
Das Vorsehen einer Temperaturkammer (12) ist beim Testen von elektronischen Bauteilen meist obligatorisch, da die Testtemperaturen im Bereich von -60°C bis + 200°C liegen können.

Werden die elektronischen Bauteile (3) beispielsweise auf einem langsam laufenden Förderband (9) zur Aufnahmestelle gefahren, steht während des Transportes auf dem Förderband (9) genügend Zeit zur Verfügung, um die Temperatur der elektronischen Bauteile (3) an die Temperatur der Temperaturkammer (12) anzugleichen.

Innerhalb der Temperaturkammer (12) finden sich zumindest die elektrische Kontakteinrichtung (8), die Handhabungseinrichtung (2) sowie der in Richtung der elektrischen Kontakteinrichtung (8) weisende Abschnitt des Fördermittels (1).

Bei den Antriebsmitteln (16) handelt es sich vorzugsweise um elektrische oder pneumatische Antriebsmittel, welche in Form von Zylindern, Stellmotoren, Schrittmotoren, Servomotoren oder Elektromagneten ausgebildet sind. Diese können beispielsweise durch einen Spindelantrieb, Schneckenantrieb, Seilzugmechanismus, Riemenantrieb, Bandantrieb, Zahnriemenantrieb, Zahnstangenantrieb, Pneumatikzylinder, flexible Wellen (22, 24), Bowdenzüge (23) oder eine Kombination hiervon wirken.

Das Fördermittel (1) kann beispielsweise ein Rüttler, eine Rutsche, oder ein Förderband sein. In der Regel wird das Fördermittel (1) durch mindestens ein Förderband (9) verkörpert, dessen Laufrichtung in der Draufsicht parallel oder rechtwinkig zur Kontaktierungsebene (7) ausgerichtet ist.
Alternativ oder zusätzlich hierzu ist es möglich, das Fördermittel (1) in Form mindestens einer manuellen oder automatischen handelsüblichen Be- und/oder Entladeeinrichtung für rohrförmige, tablettförmige, schienenförmige, stangenförmige, kassettenförmige, bandförmige oder gurtförmige Aufbewahrungsbehälter für elektronische Bauteile (3) auszubilden.

In besonders bevorzugten Ausführungsformen wird das Fördermittel (1) jedoch durch mindestens zwei im wesentlichen parallel zueinander verlaufende Förderbänder (9) verkörpert (siehe Abbildung 1).
Die Laufrichtung mindestens eines Förderbandes (9) ist dort beispielsweise rechtwinklig in Richtung der Kontaktierungsrichtung (7) ausgerichtet, während die Laufrichtung des mindestens einen weiteren Förderbandes (9) entgegengesetzt zur Laufrichtung des ersten Förderbandes ausgerichtet ist. Das zweite Förderband (9) kann beispielsweise die nach Klassen sortiert auf ihm abgelegten elektronischen Bauteile abführen. Die in Abbildung 1 dargestellten, gegebenenfalls vorhandenen Führungsschienen (21) verhindern dabei, daß sich Bauteile unterschiedlicher Güteklassen unbeabsichtigt vermischen.

Die Handhabungseinrichtung (2) umfaßt mindestens einen Bauteilhalter (18) in Form mindestens eines vorzugsweise leicht austauschbaren Greifers oder Saugers.
Ein erfindungsgemäß verwendeter Sauger (18) kann beispielsweise im wesentlichen die Form eines Rohres aufweisen und an seinem freien Ende eine gegebenenfalls mehr oder weniger aufgeweitete Aufnahmefläche (11) besitzen.
Da jeder Sauger oder Greifer konstruktionsbedingt nicht nur für eine einzige Gehäusegröße einer bestimmten Art von elektronischen Bauteilen (3,3') geeignet ist, sondern grundsätzlich zur Aufnahme und zum Transport von elektronischen Bauteilen unterschiedlichster Gehäuseabmessungen und Arten in Frage kommt, ist es im Falle der erfindungsgemäßen Transportvorrichtung nicht erforderlich, bei jedem Übergang von einer Art elektronischer Bauteile zu einer anderen oder bei jeder Größenänderung der elektronischen Bauteile (3) den Bauteilhalter (18) oder gar -wie im Stand der Technik- die gesamte Bewegungsvorrichtung für die elektronischen Bauteile (3) auszutauschen.

Der Bauteilhalter (18) ist vorzugsweise um mindestens 90° oder 180° um eine parallel zur Kontaktierungsebene (7) verlaufende Längsachse (10) beispielsweise mittels eines Bowdenzuges (23) schwenkbar (siehe Abbildungen 5 und 6). Auf diese Weise kann die in der Regel endwärtige Bauteilaufnahmefläche (11) des Bauteilhalters (18) im wesentlichen in parallele Ausrichtung zur elektrischen Kontakteinrichtung (8) und anschließend wieder in die vertikal nach unten gerichtete Ablagestellung gebracht werden.

In besonders bevorzugten Ausführungsformen umfaßt die Handhabungseinrichtung (2) ferner mindestens einen beispielsweise frontseitig auf dem in x-Richtung verschiebbaren Schlitten (17) vertikal in z-Richtung verschiebbar angebrachten zweiten Schlitten. Dieser in z-Richtung verschiebbare, zweite Schlitten kann frontseitig mindestens einen Bauteilhalter (18) tragen.
Gegebenenfalls kann eine flexible Welle (22) über ein Schneckengetriebe den vertikal gleitend an dem Schlitten (17) angebrachten weiteren Schlitten in z-Richtung antreiben.
Dies führt einerseits zu dem Vorteil, daß Orientierungsfehler des vertikal nach unten ausgerichteten Bauteilhalters (18) beim Absetzen auf dem elektronischen Baustein (3) entlang der y-Achse durch eine diesen Orientierungsfehler ausgleichende Bewegung des zweiten Schlittens entlang der z-Achse kompensierbar sind.

Die Verstellbarkeit der Handhabungseinrichtung (2) entlang der z-Achse führt darüberhinaus zu dem Vorteil, daß Orientierungsfehler bezüglich der Drehung bei einer streifenförmigen oder plattenförmigen Zusammenstellung von elektronischen Einzelbauteilen (3') besonders schnell und instrumentell einfach behebbar sind.

Wie insbesondere aus Abblidung 6 hervorgeht, kann durch simples Anheben und/oder Absenken in vertikaler z-Richtung, zumindest eines, zweier oder aller Bauteilhalter (18), ein Orientierungsfehler der platten- oder streifenförmigen Zusammenstellung um die horizontale Drehachse mühelos ausgeglichen werden.

Diese Art der Korrektur von Orientierungsfehlern ist nicht nur bei beispielsweise platten- oder streifenförmigen Zusammenstellungen von elektronischen Einzelbauteilen (3') anwendbar, sondern grundsätzlich auch bei solchen elektronischen Einzelbauteilen (3'), auf deren Gehäuseoberfläche mindestens zwei Aufnahmeflächen (11) von mindestens zwei Bauteilhaltern (18) Platz finden.

Alternativ oder zusätzlich zu dieser Art der Korrektur von Orientierungsfehlern bezüglich der Drehung elektronischer Bauteile (3) ist es möglich, die Handhabungseinrichtung (2) so auszugestalten, daß sie zumindest eine Drehung des in Kontaktierstellung hochgeschwenkten Bauteilhalters (18) um dessen Längsachse (y-Achse) gestattet.
Zu diesem Zweck kann eine flexible Welle (24) beispielsweise über ein Schneckengetriebe mit einem gegebenenfalls auf dem in z-Richtung vertikal verschiebbaren zweiten Schlitten drehbar angebrachten Rundtisch in Verbindung stehen, wobei der Rundtisch frontseitig mindestens einen Bauteilhalter (18) tragen kann. In der vertikal nach unten gerichteten Aufnahme- oder Ablagestellung des Bauteilhalters (18) kann dieser Drehmechanismus nötigenfalls gesperrt sein.

Die mindestens eine Verstelleinrichtung (4) zur Verstellung der Handhabungseinrichtung (2) umfaßt vorzugsweise im wesentlichen zwei zueinander parallele und voneinander zumindest etwas beabstandete Führungsschienen (13) sowie einen rechtwinklig zur Längsachse (14) der Führungsschienen (13) sich erstreckenden Querträger (15) (siehe insbesondere Abbildungen 2 bis 4 und 7). Der Querträger (15) ist vorzugsweise längsverschiebbar auf den Führungsschienen (13) gelagert.

Auf der in Richtung der elektrischen Kontakteinrichtung (8) weisenden Stirnseite des Querträgers (15) ist in der Regel eine Vielzahl von Handhabungseinrichtungen (2) um und/oder entlang der x-Achse und/oder der y-Achse und/oder der z-Achse verschiebbar und/oder schwenkbar angebracht. So kann die mindestens eine Handhabungseinrichtung (2) beispielsweise auf mindestens einem Schlitten (17) vorgesehen sein, welcher auf einer an der Stirnseite des Querträgers (15) vorgesehenen Führungsschiene (25) zumindest in x-Richtung, beispielsweise mittels eines Seilzugmechanismus (19), verschiebbar angebracht ist.

Die Verschiebungen oder Verschwenkungen der Handhabungseinrichtung (2) um gleiche oder unterschiedliche Achsen sind abhängig oder unabhängig voneinander vornehmbar (siehe Abbildungen 5 und 6).

Wie insbesondere aus den Abbildungen 3 und 4 hervorgeht, ist der Querträger (15) beispielsweise mittels zweier über mindestens einen Zahnriemen- oder Seilzugmechanismus (19) wirkender Antriebsmittel (16) auf den Führungschienen (13) verschiebbar.
In den in den Abbildungen 3 und 4 dargestellten Ausführungsformen der Verstelleinrichtung (4) verschieben die gleichen Antriebsmittel (16), welche den Querträger (15) verschieben, in Abhängigkeit ihrer Drehrichtung vorzugsweise zugleich eine erste Handhabungseinrichtung (2) an der Stirnseite des Querträgers (15) in x-Richtung.

Während der Kontaktierung ist -sofern erforderlich- ein beachtlicher Anpreßdruck des Querträgers (15) in Richtung der elektrischen Kontakteinrichtung (y-Richtung) aufzubringen.
Dieser kann unter Umständen zu einer Dehnung des den Querträger (15) in y-Richtung verschiebenden Transportbandes (19) führen, welche eine unbeabsichtigte Positionsveränderung der gemäß Abbildung 4 mit dem Querträger-Transportband (19) gekoppelten Handhabungseinrichtung (2) in x-Richtung zur Folge haben kann.

Sofern ein erheblicher Anpreßdruck des Querträgers (15) in y-Richtung aufzubringen ist, hat es sich zur Vermeidung unbeabsichtigter Positionsveränderungen der Handhabungseinrichtungen (2) in x-Richtung als vorteilhaft herausgestellt, den Bandantrieb (19), Zahnriemen- oder Seilzugmechanismus des Querträgers (15) nicht in Form eines umlaufenden Endlosbandes auszubilden, sondern mit seinen Endpunkten (28) mit dem Querträger (15) in feste Verbindung zu bringen (siehe Abbildung 7). Die Ansteuerung der Handhabungseinrichtungen (2) in x-Richtung erfolgt dann beispielsweise über zusätzliche, vom Querträger-Antriebsband (19) entkoppelte Seilzug-, Band- oder Zahnriemenmechanismen (19).

Wie aus Abbildung 7 hervorgeht, sorgen dann beispielsweise zwei außerhalb der Temperaturkammer befindliche, synchron angesteuerte Antriebsaggregate (16) ausschließlich für die Bewegung des Querträgers (15) in Richtung der elektrischen Kontaktiereinrichtung (8) [y-Richtung].

In der Regel sind auf der Stirnseite des Querträgers (15) weitere Handhabungseinrichtungen (2), vorzugsweise vier bis zehn, vorgesehen (siehe Abbildung 6). Diese können durch weitere Antriebsmittel (16), gegebenenfalls unabhängig von dem Querträger (15) sowie unabhängig von der ersten Handhabungseinrichtung (2), abhängig oder unabhängig voneinander entlang der x-Achse und/oder der y-Achse und/oder der z-Achse verschiebbar sein.

Bei der mindestens einen Meßvorrichtung (5) handelt es sich beispielsweise um mindestens eine mechanische oder berührungslose optische, elektrische, kapazitive oder induktive Meßvorrichtung (5).

Das Blickfeld mindestens einer Meßvorrichtung (5) ist vorzugsweise im wesentlichen auf denjenigen Abschnitt des Fördermittels (1, 9) gerichtet, welcher der elektrischen Kontakteinrichtung (8) benachbart ist und die zu bewegenden elektronischen Bauteile (3) anliefert. Hierbei kann es sich beispielsweise um eine Input-Kamera handeln, welche in der Draufsicht (live-bug) die Position, die Ausrichtung und die Abmessung des Gehäuses des angelieferten elektronischen Bauteils (3) feststellt.

In der Regel sind die Abmessungen des Gehäuses eines elektronischen Bauteils (3) toleranzbehaftet. Auch die Positionen der Kontaktmittel eines elektronischen Bauteils (3) können gegenüber dem Gehäuse des elektronischen Bauteils (3) toleranzbehaftet sein.
Zur Sicherstellung eines optimalen Kontaktes zwischen der Anordnung der Kontaktmittel des elektronischen Bauteils (3) einerseits und der elektrischen Kontakteinrichtung (8) andererseits wird in bevorzugten Ausführungsformen der erfindungsgemäßen Vorrichtung nicht nur mit einer ersten Meßvorrichtung (5), zum Beispiel mit einer Input-Kamera, in der Draufsicht (live-bug) die Abmessung, Lage und Ausrichtung des Gehäuses des elektronischen Bauteils (3) erfaßt.

Vielmehr kann über eine weitere Meßvorrichtung (5), beispielsweise eine Feinpositionierkamera mit telezentrischem Objektiv, zusätzlich die Unterseite (dead-bug) des elektronischen Bauteils (3) mit der für eine einwandfreie Kontaktierung schließlich ausschlaggebenden Anordnung von Kontaktmitteln erfaßt werden.

Wie insbesondere aus Abbildung 8 hervorgeht, kann zu diesem Zweck frontseitig zu der elektrischen Kontakteinrichtung (8) eine aus dem Bereich zwischen der elektrischen Kontakteinrichtung (8) und dem freien Ende des in Richtung der elektrischen Kontakteinrichtung (8) hochgeschwenkten Bauteilhalters (18) aus- und einschwenkbare Vorrichtung (26) zur Umlenkung elektromagnetischer Strahlung vorgesehen werden. Diese erlaubt die Abbildung der Unterseite (dead-bug) eines an einem in Richtung der elektrischen Kontakteinrichtung (8) hochgeschwenkten Bauteilhalter (18) angebrachten elektronischen Bauteils (3) auf der Abbildungsebene beispielsweise der Feinpositionierkamera (5).

Bei der Vorrichtung (26) zur Umlenkung elektromagnetischer Strahlung handelt es sich beispielsweise um einen oder mehrere schwenkbare oder feststehende, totalreflektierende oder teildurchlässige Spiegel oder Dreikant- oder Fünfkantprismen.

In Abbildung 8 schwenkt eine spiegelartige Vorrichtung (26) bei Annäherung des elektronischen Bauteils (3) nach oben weg.

Selbstverständlich ist anstelle eines Wegschwenkens nach oben ein Wegschwenken der spiegelartigen Vorrichtung (26) nach unten möglich.
Diese Ausgestaltung führt zu dem Vorteil, daß das elektronische Bauteil (3) -im Vergleich zu der Ausführungsform mit nach oben schwenkender spiegelartiger Umlenkvorrichtung (26)- früher in Richtung der elektrischen Kontakteinrichtung (8) verfahren werden kann, zumal die Gefahr einer Kollision zwischen dem heranfahrenden elektronischen Bauteil (3) und der spiegelartigen Umlenkvorrichtung (26) zu einem früheren Zeitpunkt nicht mehr gegeben ist als im Falle einer nach oben wegschwenkenden spiegelartigen Vorrichtung (26). Diese Zeitersparnis führt zu einem erhöhten Durchsatz und verbessert somit die Wirtschaftlichkeit der erfindungsgemäßen Vorrichtung.
Selbstverständlich ist es möglich, die Schwenkachse der Umlenkvorrichtung (26) -wie in Abbildung 8 dargestelltbei seitlicher Betrachtung im Bereich des Kontaktiervorrichtung-Endes der Umlenkvorrichtung (26) vorzusehen.

Alternativ oder zusätzlich hierzu kann die eine oder eine weitere Schwenkachse der Umlenkvorrichtung (26) in dem gegenüberliegenden, dem elektronischen Bauteil (3) zugewandten Bereich der Umlenkvorrichtung (26) vorgesehen werden. Von besonderem Vorteil ist in diesem Falle, daß die Feinpositionierkamera (5) dann auf besonders einfach Art und Weise einerseits die Unterseite des elektronischen Bauteils (3) und nach Aktivierung der gegenüberliegenden Drehachse andererseits auch die elektrische Kontakteinrichtung (8) betrachten und Verunreinigungen oder Abnutzungserscheinungen dort feststellen kann.

In besonders kostengünstig herzustellenden Ausführungsformen kann die Vorrichtung (26) zur Umlenkung elektromagnetischer Strahlung zur Betrachtung der Unterseite des elektronischen Bauteils (3) feststehend beispielsweise seitlich oder unter- oder oberhalb von der elektrischen Kontakteinrichtung (8) vorgesehen werden. Nachteilig ist in diesem Falle insbesondere, daß die von der Feinpositionierkamera (5) dort gewonnenen Signale unter Umständen nicht völlig mit denjenigen Werten übereinstimmen, welche nach Verschiebung des Bauteilhalters (18) in die Kontaktierungsposition vorliegen. Dies kann zu einer geringfügig nachteiligen Beeinflussung der Kontaktierungsqualität führen.

Als besonders vorteilhaft hat sich erwiesen, innerhalb des Blickfeldes der auf die Vorrichtung (26) zur Umlenkung elektromagnetischer Strahlung gerichteten Meßvorrichtung (5; Feinpositionierkamera) ein oder mehrere dem Koordinatensystem der elektrischen Kontakteinrichtung (8) eindeutig zugeordnete Referenzmarker (27) vorzusehen.
Durch das Vorsehen derartiger Referenzmarker wird eine Unabhängigkeit der Positionierung der elektronischen Bauteile (3) von der Einhaltung des exakten Einstellwinkels der spiegel- oder prismenartigen Umlenkvorrichtung (26) erreicht.
Bei den Referenzmarkern (27) kann es sich beispielsweise um Punkte, Kreuze, Einkerbungen und dergleichen handeln, welche auf der Vorrichtung (26) zur Umlenkung elektromagnetischer Strahlung angebracht, aufgedruckt oder eingespiegelt werden.

Wie in Abbildung 8 dargestellt, ist es auch möglich, die Referenzmarker (27) beispielsweise auf einer der Umlenkungsvorrichtung (26) in Richtung der Feinpositionierkamera (5) nachgeschalteten Glasplatte (30) vorzusehen.

Zur Vermeidung einer Überflutung der Feinpositionierkamera (5) mit durch die Handhabungseinrichtung (2) hervorgerufenen Hintergrundsignalen wird vorteihafterweise eine in Abbildung 8 dargestellte Sichtblende (31) vorgesehen.
Diese Sichtblende kann beispielsweise von oben und unten sowie von links und von rechts eingeschwenkt werden oder sich irisblendenartig um den Bauteilhalter (18) schließen.

Selbstverständlich ist es möglich, die Sichtblende (30) unmittelbar an dem Bauteilhalter (18) anzubringen.
Der Einsatz einer solchen Sichtblende (30) erlaubt die Verwendung einer besonders einfachen und kostengünstigen Feinpositionierkamera (5).

Alternativ oder zusätzlich zu den beiden vorbeschriebenen Meßvorrichtungen [(5) zum Beispiel Input-Kamera und Feinpositionierkamera] kann das Blickfeld der mindestens einen Meßvorrichtung (5) direkt oder indirekt den Bereich, der elektrischen Kontakteinrichtung (8) und/oder der Güteklassen entsprechenden Absetzorte (Sortierkamera) erfassen. Eine solche Sortierkamera (5) blickt beispielsweise auf den Anfangsabschnitt des die sortiert abgesetzten elektronischen Bauteile (3) abführenden Fördermittels (1, 9) oder des Aufbewahrungsbehältnisses für elektronische Bauteile (3, 3').

Es ist selbstverständlich, daß die im weitesten Sinne "optische" Maßvorrichtung (5) mit Strahlen unterschiedlichster Wellenlängen arbeiten kann. So kann insbesondere eine auf Laserstrahlung, Infrarotlicht oder Röntgenstrahlung basierende optische Meßvorrichtung (5) zum Einsatz kommen. Auf diese Weise können nicht nur Lage und Orientierung elektronischer Bauteile (3, 3') ermittelt, sondern auch deren Materialeigenschaften überprüft werden.

In einer Ausführungsform der vorliegenden Erfindung kann zumindest eine der Längsachsen der beiden Kameras (5) gegebenenfalls zumindest etwas schräg ausgerichtet und bei seitlicher Betrachtung oben in Richtung der Kontaktierungsebene (7) geneigt sein. Dies führt zu dem Vorteil, daß eine durch vorragende Baugruppen weniger verdeckte Beobachtung der Handhabungseinrichtung (2), insbesondere des Bauteilhalters (18) und der angelieferten elektronischen Bauteile (3, 3'), möglich ist.

Die Meßvorrichtung (5) steht mit der Datenverarbeitungseinrichtung und über diese mit den Antriebsmitteln (16) des Fördermittels (1, 9) und/oder der Handhabungseinrichtung (2) und/oder der Verstelleinrichtung (4) in Verbindung.

In besonders bevorzugten Ausführungsformen kann die Meßvorrichtung (5) mindestens ein weiteres kameraartiges Meßglied umfassen, dessen Blickrichtung im wesentlichen auf die elektrische Kontakteinrichtung (8) gerichtet ist.
Auch zu diesem Zwecke können beispielsweise mindestens ein Prisma und/oder mindestens ein vollständig oder teildurchlässiger Spiegel stationär oder ein- und ausschwenkbar in dem Blickfeld der mindestens einen Meßvorrichtung (5) vorgesehen sein.
Die ursprünglich im wesentlichen vertikal nach unten gerichtete Blickrichtung der mindestens einen Meßvorrichtung (5) kann auf diese Weise besonders einfach, ohne Bewegung der Meßvorrichtung (5), um beispielsweise 90° oder 180° vor allem in Richtung der elektrischen Kontakteinrichtung (8) und/oder des Absetzortes der elektronischen Bauteile (3) geschwenkt werden.

Die mindestens eine zentrale Datenverarbeitungseinrichtung enthält mindestens einen programmierbaren Mikroprozessor. Dieser ist vorzugsweise derart ausgebildet, daß er aus den von der Meßvorrichtung (5) eingehenden Meßsignalen zunächst die Lage und/oder den Drehwinkel sowie den "geometrischen Flächenschwerpunkt" des angelieferten, zu bewegenden elektronischen Bauteils (3) ermittelt.

Bei diesem "geometrischen Flächenschwerpunkt" kann es sich beispielsweise um den Schwerpunkt der in der Draufsicht erkennbaren Fläche des Gehäuses eines elektronischen Bauteils (3) handeln. Alternativ oder zusätzlich hierzu kann der "geometrische Flächenschwerpunkt" der Schwerpunkt der durch die freien Enden der gegebenenfalls beinchenförmigen Kontakte aufgespannten Fläche sein.

Der Mikroprozessor kann ferner derart ausgebildet sein, daß er auf der Basis der von der Meßvorrichtung (5) gelieferten Daten anschließend die Abweichungen des Aufsetzortes der Aufnahmefläche (11) des Bauteilhalters (18) auf dem elektronischen Bauelement (3) von dem zuvor berechneten Flächenschwerpunkt bestimmt. Der Mikroprozessor ist vorzugsweise darüber hinaus in der Weise ausgestaltet, daß er ein diese Abweichungen kompensierendes Korrektursignal ermittelt und an die Antriebsmittel (16) der Handhabungseinrichtung (2) und/oder der Verstelleinrichtung (4) solche Stellgrößen übermittelt, welche zur Feinabstimmung mit den Korrektursignalen beaufschlagt sind. Die Korrektur eines sich in der horizontalen x-y-Ebene ereignenden Orientierungsfehlers der Aufnahmefläche (11) des Bauteilhalters (13) auf einem elektronischen Bauteil (3), erfolgt erfindungsgemäß insbesondere dadurch, daß die in der Horizontalen bezüglich der y-Achse durch die Meßvorrichtung (5) festgestellte Abweichung (Δy) beim Nach-oben-Schwenken des Bauteilhalters (18) zu einer Korrektur in z-Richtung transformiert wird (Δy=Δz).
Die an die Antriebsmittel (16) von der Datenverarbeitungsanlage abgegebenen Stellgrößen sind grundsätzlich durch den Ort und die Lage des aufzunehmenden elektronischen Bauteils (3), den Ort und die Lage der elektrischen Kontakteinrichtung (8) sowie die Position und die Lage des der jeweiligen Güteklasse entsprechenden Absetzortes bestimmt.

Der mindestens eine programmierbare Mikroprozessor ist außerdem derart ausgestaltet, daß er solche Stellgrößen an die Antriebsmittel (16) der Handhabungseinrichtung (2) und der Verstelleinrichtung (4) ausgibt, daß das über den Bauteilhalter (18) aufgenommene elektronische Bauteil (3) zunächst mit einem für die Messung ausreichenden Anpressdruck paßgenau mit der elektrischen Kontakteinrichtung (8) in Eingriff kommt. Der programmierbare Mikroprozessor ist ferner derart ausgestaltet, daß die im Anschluß an die Messung an die Antriebsmittel (16) der Handhabungseinrichtung (2) und der Verstelleinrichtung (4) abgegebenen Stellgrößen bewirken, daß der mit einem elektronischen Bauteil beladene Bauteilhalter (18) aus der horizontalen oder vertikal nach oben weisenden Meßstellung nach unten schwenkt und das elektronische Bauteil (3) in Abhängigkeit von dem Prüfergebnis sortiert nach Güteklassen auf dem mindestens einen abtransportierenden Fördermittel (1) ablegt.

Die erfindungsgemäße Vorrichtung ist nicht nur zum Bewegen und Prüfen von einzelnen elektronischen Bauteilen (3) geeignet ist.
Beispielsweise kann mit erfindungsgemäßen Ausführungsformen gegebenenfalls sogar eine Zusammenstellung von mehreren elektronischen Bauteilen (3') bewegt werden, welche beispielsweise streifenförmig, gitterfeldförmig, schienenförmig, stangenförmig, rohrförmig, strangförmig, tablettförmig, bandförmig oder plattenförmig ausgebildet ist.

Zusammenfassend ist festzustellen, daß im Falle der erfindungsgemäßen Vorrichtung zum zielgerichteten Bewegen von elektronischen Bauteilen ein Spiel zwischen dem beim Stand der Technik zwingend erforderlichen platten- oder streifenförmigen Rüstsatz und den in diesen eingesetzten elektronischen Bauteilen ausgeschlossen ist. Ferner kennt die erfindungsgemäße Vorrichtung nicht das Problem einer Toleranz zwischen einem Rüstsatz und dem Prüfsockel.

Da die erfindungsgemäße Vorrichtung auf streifen- oder plattenförmige Rüstsätze grundsätzlich verzichten kann, ist ein Verschleiß derartiger Rüstsätze während des Transportes innerhalb und/oder außerhalb der Handhabungsvorrichtung oder während des Beschickens mit elektronischen Bauteilen ausgeschlossen. Dies hat eine besonders lange Standzeit der Vorrichtung sowie eine langfristig gegebene Freiheit von Toleranzen zur Folge.

Von besonderem Vorteil ist ferner, daß beim Übergang von einer Art elektronischer Bauteile zu einer anderen Art elektronischer Bauteile kein Wechsel eines platten- oder streifenförmigen Rüstsatzes oder einer Vorrichtung zur Aufnahme und zum Transport elektronischer Bauteile erforderlich ist. Dies führt zu einer erheblichen Zeit- und Kostenersparnis.

Zumal die erfindungsgemäße Vorrichtung auf Rüstsätze verzichten kann, werden keine teuren Aufbewahrungsbehälter für nicht in Gebrauch befindliche Rüstsätze benötigt.
Auch ein gut organisiertes und aufwendiges Lagersystem für nicht in Gebrauch befindliche Rüstsätze ist im Gegensatz zu den aus dem Stand der Technik bekannten Vorrichtungen überflüssig.

Aufgrund der uneingeschränkten Steuerbarkeit und der ausgeprägten Beweglichkeit des Bauteilhalters (18) um sämtliche Achsen ist eine Beschädigung von elektronischen Bauteilen (3) oder deren Kontakten (Beinchen oder Kugeln) während ihrer Bewegung ausgeschlossen.

Dies ist ein besonders gravierender Vorteil gegenüber den aus dem Stand der Technik bekannten Vorrichtungen zur Bewegung von einzelnen elektronischen Bauteilen. Denn dort werden die getesteten elektronischen Bauteile ohne Sensorik einfach abgelegt und mittels einer Zentrier- beziehungsweise Positionierfläche zentriert. Hierbei kommt es leicht zu Beschädigungen insbesondere beinchenförmiger Kontakte.

## Patentansprüche

1. Vorrichtung zum zielgerichteten Bewegen von elektronischen Bauteilen umfassend:
- mindestens ein Fördermittel (1) zur Anlieferung elektronischer Bauteile (3) in eine Temperaturkammer (12), wobei zumindest ein Abschnitt des Fördermittels (1) innerhalb der Temperaturkammer vorgesehen ist,
- mindestens eine innerhalb der Temperaturkammer (12) vorgesehene Handhabungseinrichtung (2) zur Aufnahme eines oder mehrerer elektronischer Bauteile (3) von dem Fördermittel (1) und zum Bewegen eines oder mehrerer aufgenommener elektronischer Bauteile (3) in Richtung einer elektrischen Kontakteinrichtung (8) sowie zum Ablegen von einem oder mehreren elektronischen Bauteilen (3), wobei die Handhabungseinrichtung (2) neben der Aufnahme und dem Ablegen eines oder mehrerer elektronischer Bauteile (3) ein Schwenken und/oder Verschieben und/oder Drehen mindestens eines elektronischen Bauteils (3) um die und/oder entlang der x- und/oder y- und/oder z-Achse erlaubt,
- mindestens eine Verstelleinrichtung (4) zur Verstellung der Handhabungseinrichtung (2) entlang der und/oder um die x- und/oder y- und/oder z-Achse,
- mindestens eine von der Handhabungseinrichtung (2) erreichbare, innerhalb der Temperaturkammer (12) vorgesehene elektrische Kontakteinrichtung (8) zur Herstellung mindestens einer elektrisch leitenden Verbindung zwischen mindestens einem auf seine Güte zu prüfenden elektronischen Bauteil (3) und mindestens einer der elektrischen Kontakteinrichtung (8) nachgeschalteten elektronischen Prüfeinrichtung,
- mindestens eine zentrale Datenverarbeitungseinrichtung, welche mindestens mit einer Meßvorrichtung (5) sowie mit einer der elektrischen Kontakteinrichtung (8) nachgeschalteten Prüfeinrichtung einerseits und den Antriebselementen (16) zum Antrieb der mindestens einen Handhabungseinrichtung (2) und/oder mindestens einer Verstelleinrichtung (4) und/oder des mindestens einen Fördermittels (1) andererseits in Verbindung steht,
- mindestens eine Meßvorrichtung (5) zur Bestimmung der Lage und der Ausrichtung der elektronischen Bauteile (3), und
- eine Temperaturkammer (12), außerhalb welcher die Antriebsmittel (16) zur Bewegung des mindestens einen Fördermittels (1) und/oder der mindestens einen Handhabungseinrichtung (2) und/oder der mindestens einen Verstelleinrichtung (4) vorgesehen sind.

2. Vorrichtung nach Anspruch 1, **dadurch gekennzeichnet, daß** zumindest der in Richtung der elektrischen Kontakteinrichtung (8) weisende Abschnitt des Fördermittels (1) innerhalb der Temperaturkammer (12) vorgesehen ist und daß es sich bei den Antriebsmitteln (16) um elektrische oder pneumatische Antriebsmittel handelt, welche in Form von Zylindern, Stellmotoren, Schrittmotoren, Servomotoren oder Elektromagneten ausgebildet sind, die durch einen Spindelantrieb, Schneckenantrieb, Seilzugmechanisums, Riemenantrieb, Zahnriemenantrieb, Zahnstangenantrieb, Pneumatikzylinder, flexible Wellen (22, 24) oder Bowdenzüge (23) wirken.

3. Vorrichtung nach einem der vorhergehenden Ansprüche, **dadurch gekennzeichnet, daß** das Fördermittel (1) mindestens ein Förderband (9) umfaßt, dessen Laufrichtung in der Draufsicht parallel oder rechtwinklig zur Kontaktierungsebene (7) ausgerichtet ist und/oder mindestens eine manuelle oder automatische Be- und/oder Entladeeinrichtung für rohrförmige, tablettförmige, schienenförmige, stangenförmige, kassettenförmige, gurtförmige oder bandförmige Aufbewahrungsbehältnisse für elektronische Bauteile (3).

4. Vorrichtung nach einem der vorhergehenden Ansprüche, **dadurch gekennzeichnet, daß** das Fördermittel (1) mindestens zwei im wesentlichen parallel zueinander verlaufende Förderbänder (9) umfaßt, wobei die Laufrichtung mindestens eines Förderbandes rechtwinklig in Richtung der Kontaktierungsebene (7) ausgerichtet ist, während die Laufrichtung des mindestens einen weiteren Förderbandes (9) entgegengesetzt zur Laufrichtung des ersten Bandes ausgerichtet ist.

5. Vorrichtung nach einem der vorhergehenden Ansprüche, **dadurch gekennzeichnet, daß** die Handhabungseinrichtung (2) mindestens einen Bauteilhalter (18) in Form mindestens eines Greifers oder Saugers aufweist, welcher um mindestens 90° oder 180° um eine parallel zur Kontaktierungsebene (7) verlaufende Längsachse (10) schwenkbar ist, so daß die Bauteil-Aufnahmefläche (11) des Bauteilhalters (18) im wesentlichen parallel zur elektrischen Kontakteinrichtung (8) ausgerichtet ist.

6. Vorrichtung nach einem der vorhergehenden Ansprüche, **dadurch gekennzeichnet, daß** die mindestens eine Verstelleinrichtung (4) zur Verstellung der Handhabungseinrichtung (2) im wesentlichen umfaßt:
- zwei zueinander parallel und voneinander zumindest etwas beabstandete Führungsschienen (13),
- einen rechtwinklig zur Längsachse (14) der Führungsschienen (13) sich erstreckenden Querträger (15), welcher längsverschiebbar auf den Führungsschienen (13) gelagert ist, wobei stirnseitig in Richtung der elektrischen Kontakteinrichtung (8) auf dem Querträger (15) eine Vielzahl von Handhabungseinrichtungen (2) entlang der x-Achse und/oder der y-Achse und/oder der z-Achse verschiebbar und/oder schwenkbar angebracht sind, wobei diese Verschiebungen oder Verschwenkungen der Handhabungseinrichtungen (2) um gleiche oder unterschiedliche Achsen abhängig oder unabhängig voneinander vornehmbar sind.

7. Vorrichtung nach Anspruch 6, **dadurch gekennzeichnet, daß** der Querträger (15) über einen Bandantrieb (19), Schubstangen-, Zahnstangen-, Zahnriemen- oder Seilzugmechanismus entlang den Führungsschienen (13) in Richtung der elektrischen Kontakteinrichtung (8) verschiebbar ist, wobei das oder die Antriebsmittel (16) dieses Bandantriebs (19), Schubstangen-, Zahnstangen-, Zahnriemen- oder Seilzugmechanismus gekoppelt mit oder entkoppelt sind von den in x-Richtung auf die Handhabungseinrichtungen (2) einwirkenden Antriebsmitteln (16) und wobei der gegebenenfalls vorhandene Bandantrieb (19), Zahnriemen- oder Seilzugmechanismus in Form eines umlaufenden Endlosbandes ausgebildet ist oder mit seinen Endpunkten (28) mit dem Querträger (15) in fester Verbindung steht.

8. Vorrichtung nach Anspruch 6 oder 7, **dadurch gekennzeichnet, daß** der Querträger (15) mittels zweier über mindestens einen Zahnriemen oder Seilzugmechanismus (19) wirkender Antriebsmittel (16) auf den Führungsschienen (13) verschiebbar ist, wobei diese Antriebsmittel (16) zugleich eine erste Handhabungseinrichtung (2) an der Stirnseite des Querträgers (15) in x-Richtung verschieben.

9. Vorrichtung nach einem der Ansprüche 6 bis 8, **dadurch gekennzeichnet, daß** auf dem Querträger (15) weitere Handhabungseinrichtungen (2) vorgesehen sind, welche durch weitere Antriebsmittel (16) unabhängig von dem Querträger (15) sowie von der ersten Handhabungseinrichtung (2) entlang der x-Achse verschiebbar sind.

10. Vorrichtung nach einem der vorhergehenden Ansprüche, **dadurch gekennzeichnet, daß** die Meßvorrichtung (5) mindestens eine mechanische oder mindestens eine berührungslose optische, elektrische, kapazitive oder induktive Meßvorrichtung ist, deren Blickfeld im wesentlichen auf denjenigen Abschnitt des Fördermittels (1) gerichtet ist, welcher der elektrischen Kontakteinrichtung (8) benachbart ist, wobei die mindestens eine Meßvorrichtung (5) mit der Datenverarbeitungseinrichtung und über diese mit den Antriebselementen (16) des Fördermittels (1) und/oder der Handhabungseinrichtung (2) und/oder der Verstelleinrichtung (4) in Verbindung steht.

11. Vorrichtung nach einem der vorhergehenden Ansprüche, **dadurch gekennzeichnet, daß** die mindestens eine Meßvorrichtung (5) mindestens eine Bildverarbeitungseinrichtung mit mindestens zwei kameraartigen Meßgliedern umfaßt, deren Blickrichtung im wesentlichen von oben zumindest auf den Endabschnitt des die elektronischen Bauteile (3) anliefernden Fördermittels (1, 9) und/oder auf die elektrische Kontakteinrichtung (8) und/oder auf den Anfangsabschnitt des die sortiert abgesetzten elektronischen Bauteile (3) abführenden Fördermittels (1, 9) direkt und/oder indirekt gerichtet ist, wobei die Längsachse der Blickrichtung zumindest einer der beiden kameraartigen Meßglieder bei seitlicher Betrachtung senkrecht verläuft oder oben in Richtung der elektrischen Kontaktierungsebene (7) geneigt ist.

12. Vorrichtung nach einem der vorhergehenden Ansprüche, **dadurch gekennzeichnet, daß** frontseitig zu der elektrischen Kontakteinrichtung (9) eine aus dem Bereich zwischen der elektrischen Kontakteinrichtung (8) und dem freien Ende des in Richtung der elektrischen Kontakteinrichtung (8) hochgeschwenkten Bauteilhalters (18) aus- und einschwenkbare Vorrichtung (26) zur Umlenkung elektromagnetischer Strahlung vorgesehen ist, welche die Abbildung der Unterseite eines an einem in Richtung der elektrischen Kontakteinrichtung (8) hochgeschwenkten Bauteilhalter (18) angebrachten elektronischen Bauteils (3) auf der Abbildungsebene zumindest einer kameraartigen Meßvorrichtung (5) erlaubt.

13. Vorrichtung nach einem der vorhergehenden Ansprüche, **dadurch gekennzeichnet, daß** dem Koordinatensystem der elektrischen Kontakteinrichtung (8) eindeutig zugeordnete Referenzmarker (27) innerhalb des Blickfeldes der auf die Vorrichtung (26) zur Umlenkung elektromagnetischer Strahlung gerichteten, mindestens einen Meßvorrichtung (5) vorgesehen sind.

14. Vorrichtung nach einem der vorhergehenden Ansprüche, **dadurch gekennzeichnet, daß** die mindestens eine zentrale Datenverarbeitungseinrichtung mindestens einen programmierbaren Mikroprozessor enthält, welcher derart ausgebildet ist, daß er aus den von der Meßvorrichtung (5) eingehenden Meßsignalen die Lage und/oder den Drehwinkel sowie den geometrischen Flächenschwerpunkt des zu bewegenden elektronischen Bauteils (3) ermittelt, die Abweichungen des Aufsetzortes der Aufnahmefläche (11) des Bauteilhalters (18) auf dem elektronischen Bauelement (3) von dessen Flächenschwerpunkt bestimmt und ein diese Abweichungen kompensierendes Korrektursignal ermittelt und an die Antriebsmittel (16) der Handhabungseinrichtung (2) und/oder der Verstelleinrichtung (4) Stellgrößen übermittelt, welche zur Feinabstimmung mit den Korrektursignalen beaufschlagt sind, wobei diese Stellgrößen grundsätzlich durch den Ort und die Lage des aufzunehmenden elektronischen Bauteils (3), den Ort und die Lage der elektrischen Kontakteinrichtung (8) sowie die Position und Lage des der jeweiligen Güteklasse entsprechenden Absetzortes bestimmt sind und wobei dar mindestens eine Mikroprozessor diese Stellgrößen derart an die Antriebsmittel (16) der Handhabungseinrichtung (2) und der Verstelleinrichtung (4) ausgibt, daß das über den Bauteilhalter (18) aufgenommene elektronische Bauteil (3) zunächst mit einem für die Messung ausreichenden Anpreßdruck paßgenau mit der elektrischen Kontakteinrichtung (8) in Eingriff kommt und der mit dem elektronischen Bauteil (3) beladene Bauteilhalter (18), im Anschluß an die Messung, aus der horizontalen oder vertikal nach oben weisenden Meßstellung nach unten schwenkt und das elektronische Bauteil (3) in Abhängigkeit von dem Prüfergebnis sortiert nach Güteklassen auf dem mindestens einen abtransportierenden Fördermittel (1) ablegt.

15. Vorrichtung nach einem der vorhergehenden Ansprüche, **dadurch gekennzeichnet, daß** das mindestens eine zu bewegende elektronische Bauteil (3) eine Zusammenstellung von mehreren elektronischen Einzelbauteilen (3') darstellt, welche streifenförmig, gitterfeldförmig, schienenförmig, rohrförmig, stangenförmig oder plattenförmig ausgebildet ist.

## Claims

1. Device for the targeted moving of electronic components, **characterised in that** it comprises:
- At least one conveying device (1) for the delivery of electronic components (3) ,
- At least one handling device (2) for taking up, pivoting, displacing and/or rotating about and/or along the x-axis and/or the y-axis and/or the z-axis, as well as for depositing at least one electronic component (3),
- At least one movement device (4) for moving the handling device (2) along and/or about the x-axis and/or the y-axis and/or the z-axis,
- At least one measuring device (5) for determining the position and orientation of the electronic components (3),
- At least one electrical contact device (8) for establishing at least one electrically-conductive connection between at least one electronic component (3), to be tested for its quality, and at least one electronic testing device located downstream of the electrical contact device (8),
- At least one central data-processing device (6), which is in connection at least with one measuring device (5) and with a testing device downstream of the electrical contact device (8) on the one hand, and the drive elements (16) for driving the, at least one, handling device (2) and/or the, at least one, movement device (4) and/or the, at least, one conveying media (1) on the other hand.

2. Device according to Claim 1, **characterised in that** the drive media (16) are provided for the movement of the, at least one, conveying device (1) and/or the, at least one, handling device (2) and/or the, at least one, movement device (4) outside a temperature chamber (12), inside which are located at least the electrical contact device (8) and the handling device (2) and at least the section of the conveying media (1) pointing in the direction of the electrical contact device (8), whereby the drive media (16) are electrical or pneumatic drive media, which are designed in the form of cylinders, actuating motors, stepped motors, servomotors, or electro-magnets, which take effect by means of a spindle drive, worm drive, cable drawing mechanism, belt drive, toothed belt drive, toothed bar drive, pneumatic cylinder, flexible shafts (22, 24) or Bowden cables (23).

3. Device according to one of the foregoing claims, **characterised in that** the conveying media (1) comprise at least one conveyor belt (9), the direction of run of which in the plan view is aligned parallel with or at right angles to the contacting plane (7) and/or at least one manual or automatic loading and/or unloading device, for tubular, tray-shaped, rail-shaped, bar-shaped, cassette-shaped, belt-shaped, or band-shaped storage containers for electronic components (3).

4. Device according to one of the foregoing claims, **characterised in that** the conveying media (1) comprise at least two conveyor belts (9), running essentially parallel to one another, whereby the direction of run of at least one conveyor belt is aligned at right angles in the direction of the contacting plane (7), while the direction of run of the, at least one, additional conveyor belt (9) is aligned counter to the direction of run of the first belt.

5. Device according to one of the foregoing claims, **characterised in that** the handling device (2) features at least one component holder (18) in the form of at least one gripper or suction element, which is capable of pivoting by 90° or 180° about a longitudinal axis (10) running parallel to the contacting plane (7), so that the component take-up surface (11) of the component holder (18) is aligned essentially parallel to the electrical contact device (8).

6. Device according to one of the foregoing claims, **characterised in that** the, at least one, movement device (4) for the movement of the handling device (2) comprises essentially:
- Two guide rails (13) essentially parallel to one another and spaced at least a certain amount from one another;
- A transverse carrier element (15), extending at right angles to the longitudinal axis (14) of the guide rails (13), which is mounted so as to be longitudinally extendible on the guide rails (13), whereby, on the front face in the direction of the electrical contact device (8), on the transverse carrier (15), a plurality of handling devices (2) are located along the x-axis and/or the y-axis and/or the z-axis in a displaceable manner and/or pivotable manner, whereby these displacements or pivoting movements of the handling devices (2) can be carried out about the same of different axes, dependent on or independently of each other.

7. Device according to one of the foregoing claims, **characterised in that** the transverse carrier (15) is capable of displacement along the guide rails (13) by means of a belt drive (19), thrust rod, toothed rail, toothed belt, or cable drawing mechanism, in the direction of the electrical contact device (8), whereby the drive medium or media (16) of this belt drive (19), thrust rod, toothed bar, toothed belt, or cable drawing mechanism is coupled to or uncoupled from the drive media (16) which take effect in the x-direction on the handling devices (2), and whereby the belt drive (19), toothed belt, or cable drawing mechanism which may be present if appropriate, is designed in the form of a circulating endless belt or is in a fixed connection with its end points (28) with the transverse carrier (15).

8. Device according to one of the foregoing claims, **characterised in that** the transverse carrier (15) is capable of displacement on the guide rials (16) by means of two drive media (16), which take effect by means of at least one drive belt or cable drawing mechanism (19), whereby these drive media (16) at the same time displace a first handling device (2) on the face of the transverse carrier (15) in the x-direction.

9. Device according to one of the foregoing claims, **characterised in that** additional handling devices (2) are provided on the transverse carrier (15), which are capable of displacement along the x-axis by further drive media (16), independently of the transverse carrier (15) and of the first handling device (2).

10. Device according to one of the foregoing claims, **characterised in that** the measuring device (5) is at least one mechanical or at least one contact-free optical, electrical, capacitative, or inductive measuring device, the field of vision of which is directed essentially towards that section of the conveying media (1) which is adjacent to the electrical contact device (8), whereby the, at least one, measuring device (5) is in connection via this with the drive elements (16) of the conveying media (1) and/or the handling device (2) and/or the movement device (4).

11. Device according to one of the foregoing claims, **characterised in that** the, at least one, measuring device (5) comprises at least one image-processing device with at least two camera-type measuring elements, the direction of vision of which is essentially directed from above, directly and/or indirectly, at least onto the end section of the conveying media (1, 9) delivering the electronic components (3) and/or onto the electrical contact device (8) and/or onto the beginning section of the conveying media (1, 9) removing the sorted and deposited electronic components (3), whereby the longitudinal axis of the direction of view runs perpendicular to at least one of the two measuring elements, in a side view, or is inclined upwards in the direction of the electrical contacting plane (7).

12. Device according to one of the foregoing claims, **characterised in that**, on the front face towards the electrical contact device (8), provision is made for a device (26), capable of being pivoted outwards and inwards from the area between the electrical contact device (8) and the free end of the component holder (18), pivoted upwards in the direction of the electrical contact device (8), for the deflection of electromagnetic radiation, which allows for the representation of the underside of an electronic component (3) located in a component holder (18), pivoted upwards in the direction of the electrical contact device (8), on the representation plane of at least one camera-like measuring device (5).

13. Device according to one of the foregoing claims, **characterised in that** reference markers (27) allocated unambiguously to the co-ordinate system of the electrical contact device (8) are provided for inside the field of view of the, at least one, measuring device (5) directed towards the device (26) for deflection of electromagnetic radiation.

14. Device according to one of the foregoing claims, **characterised in that** the, at least one, data-processing device (6) contains at least one programmable microprocessor, which is designed in such a way that it determines, from the measurement signals incoming from the measurement device (5), the position and/or the angle of rotation and the geometrical surface centre of gravity of the electronic component (3) which is to be moved, determines the place of deposition of the accommodation surface (11) of the component holder (18) on the electronic component (3) from the surface centre of gravity thereof, and determines a correction signal compensating for these deviations and transmits manipulated variables to the drive media (16) of the handling device (2) and/or the movement device (4), which are imposed with the correction signals for fine tuning, whereby these manipulated variables are determined essentially by the location and position of the electronic component (3) which is to be taken up, the location and position of the electrical contact device (8), and the position and location of the deposition point corresponding to the particular quality class in each case, and whereby the, at least one, microprocessor issues these manipulated variables in such a way to the drive media (16) of the handling device (2) and of the movement device (4), that the electronic component (3) taken up by the component holder (18) initially comes in contact in a precise fit with the electrical contact device (8), at a contact pressure which is sufficient for the measurement, and the component holder (18), loaded with the electronic component (3), consequent to the measurement, pivots out of the horizontal or vertical measurement position, pointing upwards, and deposits the electronic component (3), sorted by quality classes according to the test result, on the, at least one, conveying device (1) for removal.

15. Device according to one of the foregoing claims,
**characterised in that** the, at least one, electronic component (3) which is to be moved represents a compilation of several individual electronic components (3'), which are designed as strip-shaped, lattice-shaped, rail-shaped, tubular, bar-shaped, or plate-shaped.

## Revendications

1. Dispositif pour le déplacement axé sur l'objectif de composants électroniques, **caractérisé en ce qu'**il comprend :
- au moins un moyen de transport (1) pour la livraison de composants électroniques (3),
- au moins un dispositif de manipulation (2) pour le logement, pour le basculement, pour le déplacement et/ou pour la rotation autour et/ou le long de l'axe x et/ou de l'axe y et/ou de l'axe z ainsi que pour la dépose d'au moins un composant électronique (3),
- au moins un dispositif de déplacement (4) pour le déplacement du dispositif de manipulation (2) le long et/ou autour de l'axe x et/ou de l'axe y et/ou de l'axe z,
- au moins un dispositif de mesure (5) pour la détermination de l'emplacement et de l'orientation des composants électroniques (3),
- au moins un appareil de contact électrique (8) pour l'établissement d'au moins une liaison électroconductrice entre au moins un composant électronique (3), dont la qualité doit être testée, et au moins un dispositif d'essai électronique placé en aval de l'appareil de contact électrique (8),
- au moins un appareil central de traitement de données (6), qui est en liaison d'une part au moins avec un dispositif de mesure (5) et avec un dispositif d'essai placé en aval du dispositif de contact électrique (8) et d'autre part avec les éléments d'entraînement (16) pour l'entraînement du au moins un dispositif de manipulation (2) et/ou du au moins un dispositif de déplacement (4) et/ou du au moins un moyen de transport (1).

2. Dispositif selon la revendication 1, **caractérisé en ce que** les moyens d'entraînement (16) pour le déplacement du au moins un moyen de transport (1) et/ou du au moins un dispositif dé manipulation (2) et/ou du au moins un dispositif de déplacement (4) sont prévus à l'extérieur d'une chambre de température (12), à l'intérieur de laquelle se trouvent au moins le dispositif de contact électrique (8) et le dispositif de manipulation (2) et au moins la partie du moyen de transport (1) orientée en direction du dispositif de contact électrique (8), moyennant quoi, en ce qui concerne les moyens d'entraînement (16), il s'agit de moyens d'entraînement électriques ou pneumatiques, qui sont conçus sous la forme de cylindres, de moteurs de commande, de moteurs pas à pas, de servomoteurs ou d'électroaimants, qui agissent par une commande de broche, une commande à vis sans fin, un mécanisme d'entraînement par câble, un entraînement par courroie, un entraînement par courroie dentée, un entraînement par crémaillère, un vérin pneumatique, des arbres flexibles (22, 24) ou des câbles Bowden (23).

3. Dispositif selon l'une quelconque des revendications précédentes, **caractérisé en ce que** le moyen de transport (1) comprend au moins une bande transporteuse (9), dont le sens de marche est orienté, vu de dessus, parallèlement ou perpendiculairement au plan de contact (7) et/ou au moins un dispositif de chargement et/ou de déchargement manuel ou automatique pour des récipients de conservation en forme de tuyau, de plateau, de rail, de barre, de cassette, de sangle ou de bande pour des composants électroniques (3).

4. Dispositif selon l'une quelconque des revendications précédentes, **caractérisé en ce que** le moyen de transport (1) comprend au moins deux bandes transporteuses (9) sensiblement parallèles entre elles, le sens de marche d'au moins une bande transporteuse étant orienté verticalement en direction du plan de contact (7), alors que le sens de marche de la au moins une autre bande transporteuse (9) est orienté dans le sens contraire au sens de marche de la première bande.

5. Dispositif selon l'une quelconque des revendications précédentes, **caractérisé en ce que** le dispositif de manipulation (2) présente au moins un support de composant (18) sous la forme d'au moins une pince ou un suceur, lequel peut être basculé d'au moins 90° ou 180° autour d'un axe longitudinal (10) parallèle au plan de contact (7), de sorte que la surface de réception du composant (11) du support de composant (18) est orientée sensiblement parallèlement au dispositif de contact électrique (8).

6. Dispositif selon l'une quelconque des revendications précédentes, **caractérisé en ce que** le au moins un dispositif de déplacement (4) pour le déplacement du dispositif de manipulation (2) comprend essentiellement les éléments suivants :
- deux rails de guidage (13) parallèles entre eux et au moins légèrement espacés,
- une traverse (15) s'étendant perpendiculairement à l'axe longitudinal (14) des rails de guidage (13), laquelle est logée sur les rails de guidage (13) de façon coulissante dans le sens longitudinal, moyennant quoi sur la face avant en direction du dispositif de contact électrique (8), un grand nombre de dispositifs de manipulation (2) sont disposés sur la traverse (15) de façon à pouvoir coulisser et/ou pivoter, le long de l'axe x et/ou de l'axe y et/ou de l'axe z, moyennant quoi ces déplacements ou basculements du dispositif de manipulation (2) peuvent être effectués autour d'axes identiques ou différents, de façon dépendante ou indépendante les uns des autres.

7. Dispositif selon l'une quelconque des revendications précédentes, **caractérisé en ce que** la traverse (15) peut être déplacée au moyen d'un entraînement à bande (19), d'un mécanisme à tige de poussée, à crémaillère, à courroie crantée ou à câble le long des rails de guidage (13) en direction du dispositif de contact électrique (8), moyennant quoi le ou les moyens d'entraînement (16) de cet entraînement à bande (19), mécanisme à tige de poussée, à crémaillère, à courroie crantée ou câble sont couplés ou découplés avec des moyens d'entraînement (16) agissant dans le sens x sur les dispositifs de manipulation (2) et moyennant quoi l'entraînement à bande (19), le mécanisme à courroie crantée ou à câble éventuellement présent est conçu sous la forme d'une bande sans fin périphérique et est en liaison fixe avec ses points d'extrémité (28) avec la traverse (15).

8. Dispositif selon l'une quelconque des revendications précédentes, **caractérisé en ce que** la traverse (15) peut être déplacée sur les rails de guidage (13) au moyen de deux moyens d'entraînement (16) agissant par au moins une courroie crantée ou un mécanisme à câble (19), moyennant quoi ces moyens d'entraînement (16) déplacent en même temps un premier dispositif de manipulation (2) sur la face avant de la traverse (15) dans le sens x.

9. Dispositif selon l'une quelconque des revendications précédentes, **caractérisé en ce qu'**il est prévu sur la traverse (15) d'autres dispositifs de manipulation (2) qui peuvent être déplacés par d'autres moyens d'entraînement (16) indépendamment de la traverse (15) et du premier dispositif de manipulation (2) le long de l'axe x.

10. Dispositif selon l'une quelconque des revendications précédentes, **caractérisé en ce que** le dispositif de mesure (5) est un au moins un dispositif de mesure mécanique ou au moins un dispositif de mesure optique, électrique, capacitif ou inductif sans contact, dont le champ de vision est axé essentiellement sur la partie du moyen de transport (1) qui est voisine du dispositif de contact (8) électrique, moyennant quoi le au moins un dispositif de mesure (5) est en liaison avec le système de traitement de données (6) et par celui-ci avec les éléments d'entraînement (16) du moyen de transport (1) et/ou du dispositif de manipulation (2) et/ou du dispositif de déplacement (4).

11. Dispositif selon l'une quelconque des revendications précédentes, **caractérisé en ce que** le au moins un dispositif de mesure (5) comprend au moins un système de traitement d'images avec au moins deux éléments de mesure du type caméra, dont la direction de visée est axée directement ou indirectement essentiellement par le haut au moins sur la section d'extrémité du moyen de transport (1, 9) fournissant les composants électroniques (3) et/ou sur le dispositif de contact électrique (8) et/ou sur la section initiale du moyen de transport (1, 9) évacuant les composants électroniques (3) déposés triés, l'axe longitudinal de la direction de visée étant perpendiculaire au moins à l'un des deux éléments de mesure du type caméra si on regarde par le côté ou est penché en haut en direction du plan de contact électrique (7).

12. Dispositif selon l'une quelconque des revendications précédentes, **caractérisé en ce que** sur l'avant par rapport au dispositif de contact électrique (8), il est prévu un dispositif (26) pouvant sortir et entrer par basculement dans la zone comprise entre le système de contact électrique (8) et l'extrémité libre du support de composant (18) relevé en direction du système de contact électrique (8) pour la déviation de rayonnement électromagnétique, qui permet la reproduction du côté inférieur d'un composant électronique (3) disposé sur un support de composant (18) relevé en direction du système de contact électrique (8) sur le plan de reproduction d'au moins un dispositif de mesure (5) du type caméra.

13. Dispositif selon l'une quelconque des revendications précédentes, **caractérisé en ce qu'**il est prévu des repères de référence (27) clairement attribués au système de coordonnées du dispositif de contact (8) électrique à l'intérieur du champ de vision du au moins un dispositif de mesure (5) orienté sur le dispositif (26) pour la déviation de rayonnement électromagnétique.

14. Dispositif selon l'une quelconque des revendications précédentes, **caractérisé en ce que** le au moins un système central de traitement de données (6) contient au moins un microprocesseur programmable qui est conçu de telle sorte qu'il détermine à partir des signaux de mesure arrivant du dispositif de mesure (5) l'emplacement et/ou l'angle de rotation ainsi que le centre de gravité géométrique de surface du composant électronique (3) à déplacer, détermine les écarts du lieu de dépose de la surface de réception (11) du support de composant (18) sur le composant (3) électronique par rapport à son centre de gravité de surface et détermine un signal de correction composant ces écarts et transmet aux moyens d'entraînement (16) du dispositif de manipulation (2) et/ou du dispositif de réglage (4) des grandeurs de commande qui sont sollicitées pour l'ajustage fin avec les signaux de correction, ces grandeurs de commande étant déterminées en principe par l'emplacement et la position du composant (3) électronique à recevoir, l'emplacement et la position du dispositif de contact électrique (8) ainsi que la position et l'emplacement du lieu de dépose correspondant à la classe de qualité respective et moyennant quoi le au moins un microprocesseur envoie ces grandeurs de commande aux moyens d'entraînement (16) du dispositif de manipulation (2) et du dispositif de réglage (4) de telle sorte que le composant (3) électronique réceptionné par le support de composant (18) est en prise d'abord avec une pression d'appui suffisante pour la mesure de façon ajustée avec le dispositif de contact (8) électronique et support de composant (18) chargé avec le composant électronique (3) bascule, à la suite de la mesure, de la position de mesure horizontale ou dirigée verticalement vers le haut, vers le bas et dépose le composant électronique (3) en fonction du résultat de l'essai trié par classes de qualité sur le au moins un moyen de transport (1) d'évacuation.

15. Dispositif selon l'une quelconque des revendications précédentes, **caractérisé en ce que** le au moins un composant électronique (3) à déplacer représente un regroupement de plusieurs composants individuels (3') électroniques, qui sont conçus sous forme de bande, de zone de grille, de rail, de tuyau, de tige ou de plaque.
